(19) Europäisches Patentamt
European Patent Office
Office européen des brevets

(11) **EP 2 103 947 A1**

(12) **EUROPEAN PATENT APPLICATION**
published in accordance with Art. 153(4) EPC

(43) Date of publication:
**23.09.2009 Bulletin 2009/39**

(51) Int Cl.:
***G01R 19/00*** *(2006.01)*

(21) Application number: **07831198.2**

(22) Date of filing: **05.11.2007**

(86) International application number:
**PCT/JP2007/071465**

(87) International publication number:
**WO 2008/084593 (17.07.2008 Gazette 2008/29)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **11.01.2007 JP 2007003019**
**07.05.2007 JP 2007122080**

(71) Applicant: **Panasonic Corporation**
**Kadoma-shi**
**Osaka 571-8501 (JP)**

(72) Inventors:
• **YOSHIDA, Koji**
**Osaka-shi, Osaka 540-6207 (JP)**
• **ODAJIMA, Yoshimitu**
**Osaka-shi, Osaka 540-6207 (JP)**
• **HANDA, Hiroyuki**
**Osaka-shi, Osaka 540-6207 (JP)**

(74) Representative: **Pautex Schneider, Nicole Véronique et al**
**Novagraaf International SA**
**25, avenue du Pailly**
**1220 Les Avanchets - Geneva (CH)**

(54) **VOLTAGE DETECTOR FOR STORAGE ELEMENT**

(57)     A voltage detector for a storage element that includes a positive electrode and a negative electrode, both being biased to a positive voltage, is disclosed. The voltage detector includes a first PNP transistor of which emitter terminal is connected to the negative terminal and its base terminal is connected to its collector terminal, a voltage-current converter of which first end is connected to the positive electrode, a second PNP transistor of which emitter terminal is connected to a second end of the converter and its base terminal is connected to the base terminal of the first PNP transistor, a current source connected to the collector terminal of the first PNP transistor for drawing a current from the collector terminal, a current sensing circuit connected to the collector terminal of the second PNP transistor for sensing a collector current, and a voltage output circuit for outputting a voltage across the positive electrode and the negative electrode based on an output from the current sensing circuit. The foregoing structure allows the voltage detector to detect a voltage across the storage element accurately at a high speed.

FIG. 1

**Description**

**TECHNICAL FIELD**

The present invention relates to a voltage detector for detecting a voltage across a storage element.

**BACKGROUND ART**

In recent years, a hybrid car driven by not only an engine but also by a motor and an electric vehicle driven only by a motor have been developed in order to protect an environment or improve fuel efficiency. In these vehicles, multiple storage elements (e.g. secondary batteries or capacitors) are mounted for the motor to drive the vehicle.

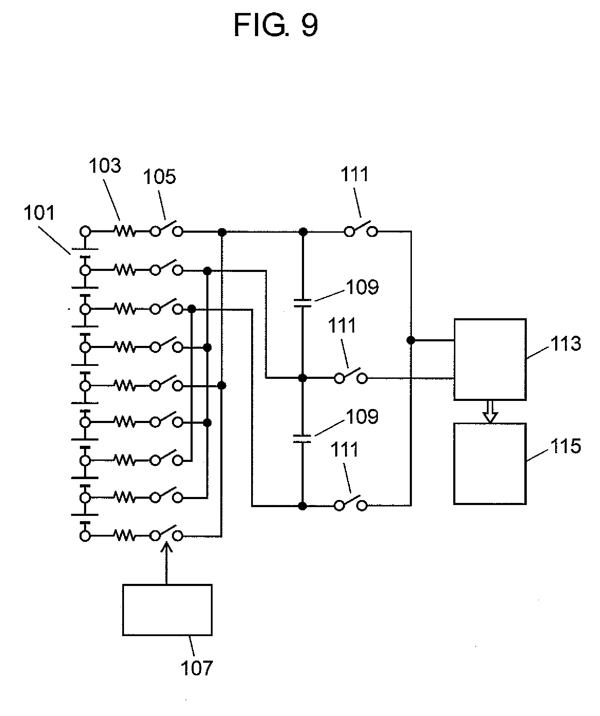

It is necessary to detect a voltage across the respective storage elements for controlling a charge/discharge or detecting an abnormality. A method of detecting the voltage across each one of the elements is disclosed in, e.g. patent document 1 described below. Fig. 9 shows a block circuit diagram of a voltage detector disclosed in patent document 1. In Fig. 9, multiple storage elements 101 (eight secondary batteries are used here) are coupled together in series. Respective terminals of each one of elements 101 are connected to selector switches 105 via resistors 103 respectively. Selector switch 105 is formed of multiplexer, and selector-switch driving circuit 107 controls the selecting operation of switch 105. An output from switch 105 is supplied to one of the terminals of flying capacitors 109 connected in series. Each one of the terminals of capacitors 109 is connected to sampling switch 111, so that three sampling switches 111 are available in Fig. 9. An output from each one of switches 111 is supplied to voltage sensing circuit 113, of which output is supplied to abnormality determining circuit 115.

The voltage detector discussed above operates this way: First, selector-switch driving circuit 107 turns on, e.g. the upper most selector switch 105 in Fig. 9 and selector switch 105 next to the upper most one. At this time, every sampling switch 111 is turned off in advance. As a result, a voltage across the upper most storage element 101 in Fig. 9 is copied to flying capacitor 109 placed on the upper side. Next, driving circuit 107 turns off every selector switch 105, and then upper most sampling switch 111 and switch 111 next to the upper most one are turned on. As a result, a voltage across the upper most storage element 101 is supplied to voltage sensing circuit 113, which then outputs this voltage to abnormality determining circuit 115. If this voltage is something wrong, circuit 115 outputs a signal of abnormality to the outside.

The operation discussed above is carried out sequentially for every storage element 101, so that voltage sensing circuit 113 can find respective voltages across each one of storage elements 101, and abnormality determining circuit 115 can detect an abnormality in storage elements 101.

The foregoing storage device needs to copy the voltage across each one of storage elements 101 sequentially to flying capacitor 109 by turning on or off selector switch 105 or sampling switch 111 before sensing circuit 113 senses the voltage. Since it takes a time before all the voltages across every storage element 101 are detected, if the voltage changes during the detection, the accuracy of detecting the voltage is degraded although every voltage across each one of storage elements 101 can be found.

Patent Document 1: Unexamined Japanese Patent Application Publication No. 2002 - 281681

**DISCLOSURE OF INVENTION**

The present invention aims to provide an accurate voltage detector for storage elements, and the detector can detect a voltage across storage element 101 at a high speed. The voltage detector detects a voltage of the storage element having a positive electrode and a negative electrode, and the detector comprises the following structural elements:

    (1) a first PNP transistor connected to the negative electrode at its emitter terminal with its base terminal connected to its collector terminal;
    (2) a voltage-current converter connected to the positive electrode at its first end;
    (3) a second PNP transistor connected to a second end of the voltage-current converter at its emitter terminal with its base terminal connected to the base terminal of the first PNP transistor;
    (4) a current source connected to the collector terminal of the first PNP transistor and drawing an electric current from the collector terminal;
    (5) a current sensing circuit connected to the collector terminal of the second PNP transistor for sensing the collector current; and
    (6) a voltage output circuit for outputting a voltage across the positive and negative electrodes based on the output from the current sensing circuit. The negative electrode of the storage element is biased to a positive voltage with respect to the current sensing circuit.

The voltage detector for the storage elements drives the current source, thereby drawing an electric current from the collector terminal of the first PNP transistor, so that the collector current of the second PNP transistor becomes proportionate to the voltage across the storage element. This collector current is then sensed by the current sensing circuit, so that the voltage across the storage element can be output from the voltage output circuit. An installation of this voltage detector to the respective storage elements allows detecting directly the voltage across each one of the storage elements, thereby shortening the detecting time advantageously, and yet, the voltage detector can accurately detect the voltage.

Another voltage detector of the present invention for storage elements having a positive electrode and a negative electrode comprises the following structural elements:

(1) a first NPN transistor connected to the positive electrode at its emitter terminal with its base terminal connected to its collector terminal;
(2) a voltage-current converter connected to the negative electrode at its first end;
(3) a second NPN transistor connected to a second end of the voltage-current converter at its emitter terminal with its base terminal connected to the base terminal of the first NPN transistor;
(4) a current source connected to the collector terminal of the first NPN transistor and supplying an electric current to the collector terminal;
(5) a current sensing circuit connected to the collector terminal of the second NPN transistor for sensing the collector current; and
(6) a voltage output circuit for outputting a voltage across the positive and negative electrodes based on the output from the current sensing circuit. The positive electrode of the storage element is biased to a negative voltage with respect to the current sensing circuit.

The voltage detector for the storage elements drives the current source, thereby supplying an electric current to the collector terminal of the first NPN transistor, so that the collector current of the second NPN transistor becomes proportionate to the voltage across the storage element. This collector current is then sensed by the current sensing circuit, so that the voltage across the storage element can be output through the current output circuit and the voltage output circuit. Similar to the structure discussed previously, the foregoing structure thus can shorten the detecting time advantageously, and yet, can detect the voltage accurately.

## BRIEF DESCRIPTION OF THE DRAWINGS

Fig. 1 shows a block circuit diagram of a voltage detector, employing PNP transistors, for storage elements in accordance with a first embodiment of the present invention.
Fig. 2 shows another block circuit diagram of a voltage detector, employing PNP transistors, for storage elements in accordance with the first embodiment of the present invention.
Fig. 3 shows a block circuit diagram of a voltage detector, employing P-type FETs, for storage elements in accordance with the first embodiment of the present invention.
Fig. 4 shows a block circuit diagram of a voltage detector, employing NPN transistors, for storage elements in accordance with a second embodiment of the present invention.
Fig. 5 shows a block circuit diagram of a voltage detector, employing N-type FETs, for storage elements in accordance with the second embodiment of the present invention.
Fig. 6 shows a block circuit diagram of a voltage detector for storage elements in accordance with a third embodiment of the present invention.
Fig. 7 shows relations between an actual voltage Vcr across an storage element and voltage Vo supplied from a current sensing circuit of a voltage detector for storage elements in accordance with the third embodiment of the present invention.
Fig. 8 shows a block circuit diagram of a voltage detector, employing PNP transistors, for storage elements in accordance with a fourth embodiment of the present invention.
Fig. 9 shows a block circuit diagram of a conventional voltage detector.

## DESCRIPTION OF REFERENCE MARKS

11    storage element

| 20 | voltage detector |
|---|---|
| 21 | positive electrode |
| 23 | negative electrode |
| 25 | first PNP transistor |
| 27 | voltage-current converter |
| 29 | second PNP transistor |
| 31 | current source |
| 32 | driving switch |
| 33 | current sensing circuit |
| 35 | voltage output circuit |
| 39 | first P-type FET |
| 41 | second P-type FET |
| 43 | first NPN transistor |
| 45 | second NPN transistor |
| 47 | first N-type FET |
| 49 | second N-type FET |
| 61 | max. voltage positive electrode |
| 63 | reference current input section |
| 64 | reference current resistor |
| 65 | current compensating resistor |
| 67 | min. voltage negative electrode |

**PREFERRED EMBODIMENTS OF INVENTION**

Exemplary embodiments of the present invention are demonstrated hereinafter with reference to the accompanying drawings.

**EMBODIMENT 1**

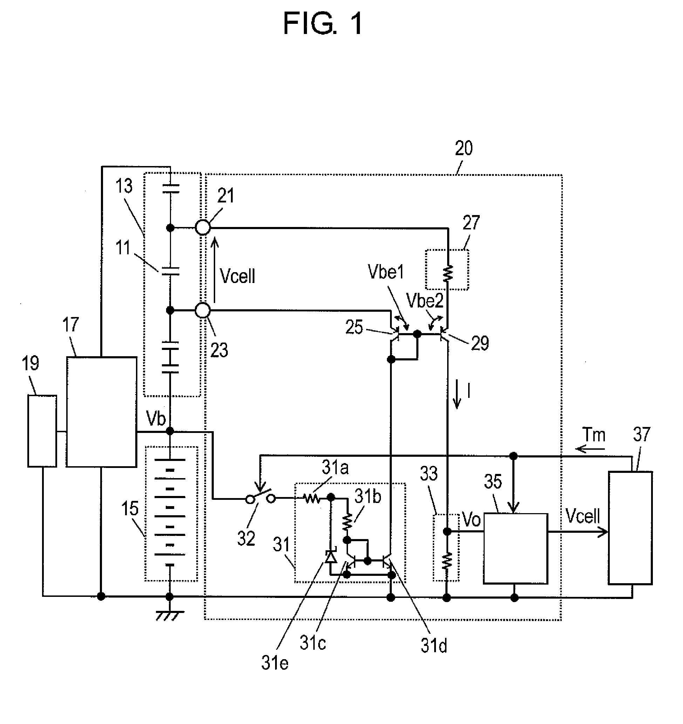

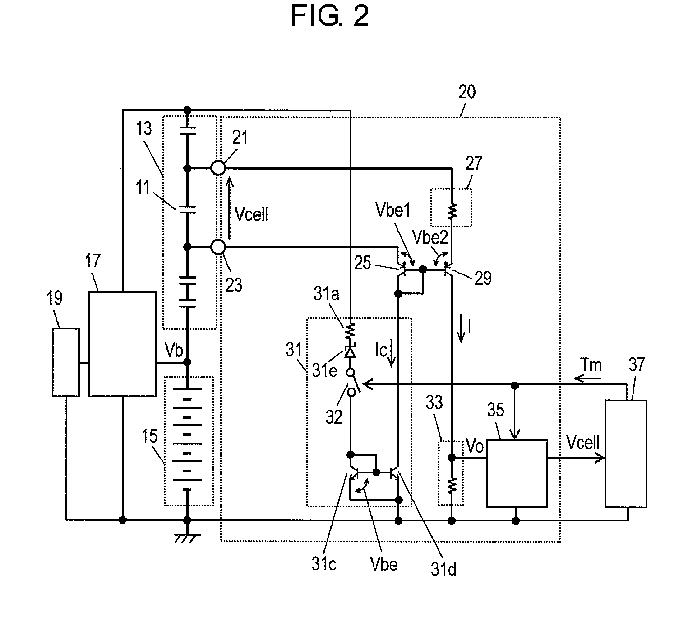

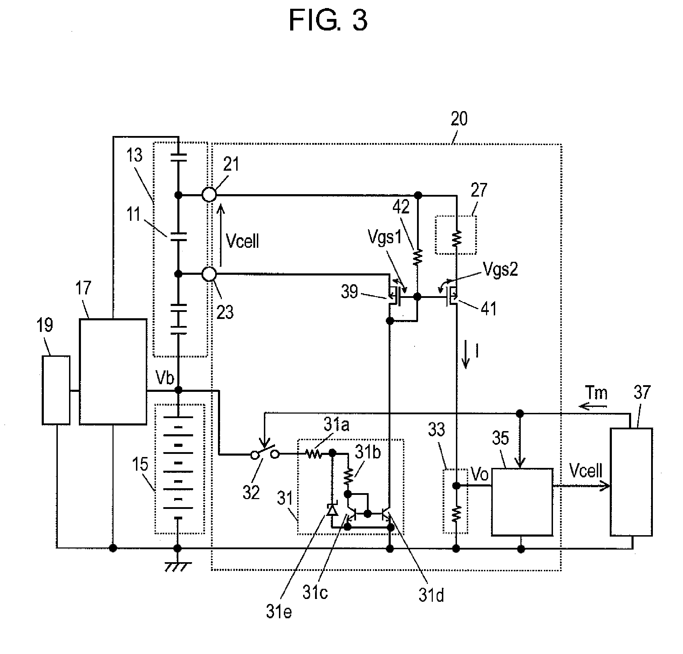

Fig. 1 shows a block circuit diagram of a voltage detector, employing PNP transistors, for storage elements in accordance with the first embodiment of the present invention. Fig. 2 shows another block circuit diagram of a voltage detector, employing PNP transistors, for storage elements in accordance with the first embodiment of the present invention. Fig. 3 shows a block circuit diagram of a voltage detector, employing P-type FETs, for storage elements in accordance with the first embodiment of the present invention.

In Fig. 1, multiple storage elements 11 are connected together in series, thereby forming electric storage section 13. Storage element 11 is formed of an electrically double-layered capacitor excellent in quick charge/discharge performance. Storage section 13 is also connected in series to secondary battery 15. In this status as shown in Fig. 1, since electric storage section 13 is connected to the positive electrode of secondary battery 15, every storage element 11 is biased to a positive voltage. Storage section 13 and secondary battery 15 are connected to charge/discharge device 17, so that a charge to storage section 13 or secondary battery 15 and a discharge to load 19 can be controlled.

Voltage detector 20 for detecting a voltage across each one of storage elements 11 is detailed hereinafter. Since storage element 11 is formed of an electrically double-layered capacitor, it has positive electrode 21 and negative electrode 23, which is connected with the emitter terminal of first PNP transistor 25. The base terminal and the collector terminal of first PNP transistor 25 are connected together.

Positive electrode 21 is connected with a first end of voltage-current converter 27, which is formed of a resistor having resistance value R in this first embodiment. A second end of converter 27 is connected with the emitter terminal of second PNP transistor, of which base terminal is connected to the base terminal of first PNP transistor 25.

First PNP transistor 25 is connected to current source 31 at its collector terminal, and current source 31 draws an electric current from the collector terminal of first PNP transistor 25. Current source 31 is formed of two resistors 31a and 31b, two transistors 31c and 31d, one Zener diode 31e as shown in Fig. 1. The driving power for current source 31 has its ON-OFF operation controlled by driving switch 32 such that current source 31 is driven only when a voltage across storage element 11 is detected and is not driven during the other times.

Second PNP transistor 29 is connected to current sensing circuit 33 at its collector terminal for sensing a collector current of transistor 29. To be more specific, current sensing circuit 33 is formed of a resistor having a resistance value R0. Positive electrode 21 and negative electrode 23 are coupled to current sensing circuit 33 such that both the electrodes are biased positively with respect to circuit 33. Therefore, when corrector current I flows through current sensing circuit 33, output voltage Vo from sensing circuit 33 is expressed as Vo = R0 × I, so that the current value can be proportionately converted to a voltage value.

The output from current sensing circuit 33 is supplied to voltage output circuit 35, which converts voltage Vo supplied from circuit 33 into voltage Vcell across positive electrode 21 and negative voltage 23.

Voltage detector 20 for storage elements 11 is constructed as discussed above. Fig. 1 shows the block diagram in which only one storage element 11 among multiple elements 11 is connected to voltage detector 20; however, this is for the description purpose and the other elements 11 are actually also connected to voltage detector 20. Similarly to storage elements 11, voltage detector 20 can be connected to each one of secondary batteries 15 individually.

An output from voltage output circuit 35 is supplied to control circuit 37 formed of a microprocessor, which thus can detect voltage Vcell across storage element 11. Control circuit 37 transmits voltage detection timing signal Tm to both of driving switch 32 and voltage output circuit 35.

The operation of foregoing voltage detector 20 for storage element 11 is demonstrated hereinafter. When a timing for detecting voltage Vcell across storage element 11 comes (e.g. every time after a given time elapses), control circuit 37 transmits voltage detection timing signal Tm to both of driving switch 32 and voltage output circuit 35. Receiving this signal, driving switch 32 is turned on, and voltage output circuit 35 operates such that it outputs voltage Vcell across storage element 11.

The turn-on of driving switch 32 drives current source 31, which then draws current from the collector terminal of first PNP transistor 25, which is thus forward biased across its base and emitter, thereby generating voltage Vbe1. The base terminal of second PNP transistor 29 is connected to the base terminal of first PNP transistor 25, so that the base voltages of transistors 25 and 29 become equal. The emitter terminal of second PNP transistor 29 is connected to positive electrode 21 via voltage-current converter 27, i.e. the resistor 27 having resistance value R, so that it is forward biased. Voltage Vbe2 is thus generated across the base and emitter of second PNP transistor 29, and an emitter current flows there.

When first PNP transistor 25 and second PNP transistor 29 are forward biased, their base-emitter voltages become almost equal (i.e. Vbe1 ≈ Vbe2) to each other, so that a voltage at the emitter terminal of second PNP transistor 29 virtually equals to a voltage of negative electrode 23. As a result, voltage Vcell across storage element 11 is applied to voltage-current converter 27, so that the emitter current of second PNP transistor 29 is counted as Vcell/R. Since second PNP transistor 29 is forward biased, its emitter current mostly flows to the collector terminal, and collector current I is counted as Vcell/R (collector current I = Vcell/R).

The mechanism discussed above allows collector current I of second PNP transistor 29 to be proportionate to voltage Vcell across electric storage device 11 and flow into current sensing circuit 33. As a result, current sensing circuit 33 outputs voltage Vo that is expressed as a product of multiplying resistance value R0 of the resistor forming current sensing circuit 33 by collector current I. When voltage Vo is supplied to voltage-output circuit 35, which then converts voltage Vo into voltage Vcell across storage element 11. At this time, control circuit 37 has required circuit 35 to supply voltage Vcell, so that circuit 35 supplies immediately voltage Vcell to control circuit 37 immediately after the conversion.

Control circuit 35 can thus detect voltage Vcell across storage element 11, and the structure discussed above allows eliminating sequential turn-on/off of multiple switches as well as a copy of the voltage to the flying capacitor, so that voltage detector 20 in accordance with the first embodiment can detect voltage Vcell more quickly than the conventional voltage detector. As a result, if the performance of load 19 of secondary battery 15 changes drastically, an absolute value of voltage Vcell undergoing the detector is negligibly affected by this change because voltage Vcell is detected by control circuit 37 directly, and an accurate detection of voltage Vcell across storage element 11 can be expected.

After detecting voltage Vcell across each one of storage elements 11, control circuit 37 transmits voltage detection timing signal Tm for turning off driving switch 32. The turn-off of driving switch 32 prompts current source 31 to stop drawing the current from the collector terminal of first PNP transistor 25. At the same time, the supply of base current is halted to first PNP transistor 25 and second PNP transistor 29, so that these transistors are turned off. Collector current I of second PNP transistor 29 thus becomes 0 (null), so that extra discharge from storage elements 11 can be reduced because driving switch 32 is turned on only when voltage Vcell across storage element 11 is detected.

Repeat of the foregoing operation allows reducing extra discharge from storage element 11 while voltage Vcell across each one of elements 11 is detected.

In this first embodiment, since positive electrode 21 and negative electrode 23 of storage element 11 are biased to a positive voltage by secondary battery 15, a high voltage with respect to the collector terminal is applied to the emitter terminals of first PNP transistor 25 and second PNP transistor 29 during the detection of the voltages. This is the reason why the PNP transistors are used in this embodiment.

When first PNP transistor 25 and second PNP transistor 29 are forward biased, it is explained that voltage Vbe1 across the base and emitter of transistor 25 is almost equal to voltage Vbe2 across the base and emitter of transistor 29; however, actually a little difference occurs between Vbe1 and Vbe2 because of dispersion in the characteristics of the transistors and difference in the currents flowing through them. To cancel this difference between Vbe1 and Vbe2, the following preparation is needed: Set a resistance value of resistor 31b of current source 31 such that the current of current source 31 becomes almost equal to the collector current of second PNP transistor, and employ first PNP transistor 25 and second PNP transistor 29 uniform in the characteristics. This preparation allows obtaining more accurate voltage Vcell.

On top of that, the current of current source 31 is varied to become approximately proportionate to the voltage across positive electrode 21 and negative electrode 23 of storage element 11 (i.e. voltage Vcell), then the difference between Vbe1 and Vbe2 becomes smaller even if Vcell changes. As a result, voltage Vcell can be detected much more accurately because an error becomes smaller. Fig. 2 shows an example of this circuit structure.

Fig. 2 differs from Fig. 1 in an internal wiring of current source 31 and a connection of driving switch 32. To be more specific, the collector terminal of transistor 31c is connected to first end of driving switch 32, and a second end thereof is connected with Zener diode 31e and resistor 31a, having resistance value Rc, in this order.

The other end of resistor 31a is connected to the max. voltage output from storage section 13. Zener diode 31e is selected to satisfy the condition of Vb = Vbe + Vz, where Vbe is a voltage across the base and emitter of transistor 31c, Vz is a Zener voltage, and Vb is an output voltage of secondary battery 15. This selection makes this condition: Ic = Vc/Rc, where Ic is the collector current of first PNP transistor 25, namely, the current drawn by current source 31. Since voltage Vcell across storage element 11 is proportionate to voltage Vc across storage section 13, collector current Ic is to proportionate voltage Vcell.

The foregoing structure allows the current (=Ic) of current source 31 to vary almost proportionately to voltage Vcell across storage element 11, so that much more accurate voltage detector 20 is obtainable.

The operation and the structure discussed above prove that the voltage detector which can detect the voltage across the storage element accurately at a high speed is obtainable.

In this first embodiment, first PNP transistor 25 and second PNP transistor 29 are employed; however, as the circuit structure shown in Fig. 3 depicts, these transistors can be replaced with first P-type FET 39 and second P-type FET 41 respectively. In this case, off-resistor 42 is connected between the gate terminal of second P-type FET 41 and positive electrode 21 in order to surely turn off both of FET 39 and FET 41. The circuit shown in Fig. 3 except this part remains unchanged from the circuit shown in Fig. 1, so that circuit elements in Fig. 3 have the same reference marks as those in Fig. 1. The source terminals, gate terminals, and drain terminals of the FETs are connected as described below:

First P-type FET 39 is connected this way, the source terminal is connected to negative electrode 23, the gate terminal and the drain terminal are coupled together, and the drain terminal is connected with current source 31. This means that the connection to the emitter terminal, base terminal and collector terminal of first PNP transistor 25 is applied to the connection to the source terminal, gate terminal and drain terminal of first P-type FET 39 respectively, so that current source 31 draws the current from the drain terminal.

Second P-type FET 41 is connected this way: the source terminal is connected to a first end of voltage-current converter 27, and the gate terminal is connected to the gate terminal of first P-type FET, and the drain terminal is connected with current sensing circuit 33. This means that the connection to the emitter terminal, base terminal and collector terminal of second PNP transistor 29 is applied to the connection to the source terminal, gate terminal and drain terminal of second P-type FET 41 respectively, so that drain current I can be sensed.

The operation of the structure shown in Fig. 3 is similar to that shown in Fig. 1. To be more specific, first P-type FET 39 is connected to second P-type FET 41 at their gate terminals. When they are forward biased by the current drawn by current source 31, voltages Vgs1 and Vgs2 are generated across the respective gates and sources. In this condition, assume that gate threshold voltage Vth (not shown) of both the FETS are equal to each other, and a great conductive admittance exists in a forward direction, then $Vgs1 \approx Vgs2$ is fond, and a source voltage of second P-type FET 41 becomes virtually equal to the voltage of negative electrode 23. Therefore, similar to Fig. 1, the source current of second P-type FET 41 is counted as Vcell/R, and the source current flows mostly to the drain terminal, so that the source current becomes almost equal to drain current I. As a result, the equation of I = Vcell/R is found. The flow of drain current I through current sensing circuit 33 and voltage output circuit 35 allows detecting voltage Vcell across storage element 11 at a high speed.

When current source 31 is turned off, the gate voltages of both of first P-type FET 39 and second P-type FET 41 become the voltage of positive electrode 21 due to the presence of off-resistor 42, so that both of the FETs are surely turned off. As a result, no current flows, and thus extra discharge from storage elements 11 can be reduced.

In the structure shown in Fig. 1, a base current slightly flows both in first PNP transistor 25 and second PNP transistor 29, so that collector current I includes some error due to this small base current. However, since the structure shown in Fig. 3 employs first P-type FET 39 and second P-type FET 41, there is no current corresponding to the base current, so that the error can be reduced, and thus voltage Vcell across storage elements 11 can be detected more accurately than that can be detected by the structure shown in Fig. 1.

Similarly to the case shown in Fig. 1, the preparations below allow obtaining much more accurate voltage Vcell: Use first P-type FET 39 and second P-type FET 41 uniform in the characteristics, and set a resistance value of resistor 31b of current source 31 such that the currents flowing the two FETs have no difference.

In the structure shown in Fig. 3, a high voltage with respect to the drain terminal is applied to the source terminals of first P-type FET 39 and second P-type FET 41 during the detection of the voltages. This is the reason why the P-type FETs are used.

## EMBODIMENT 2

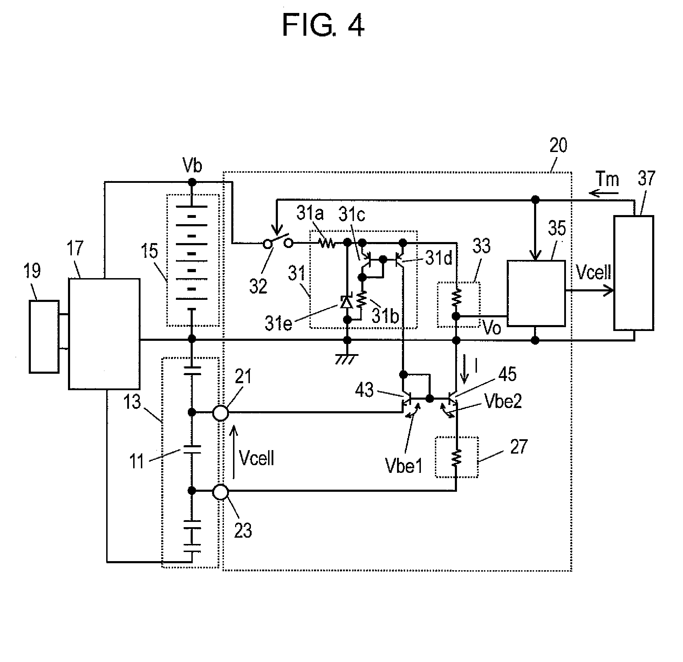

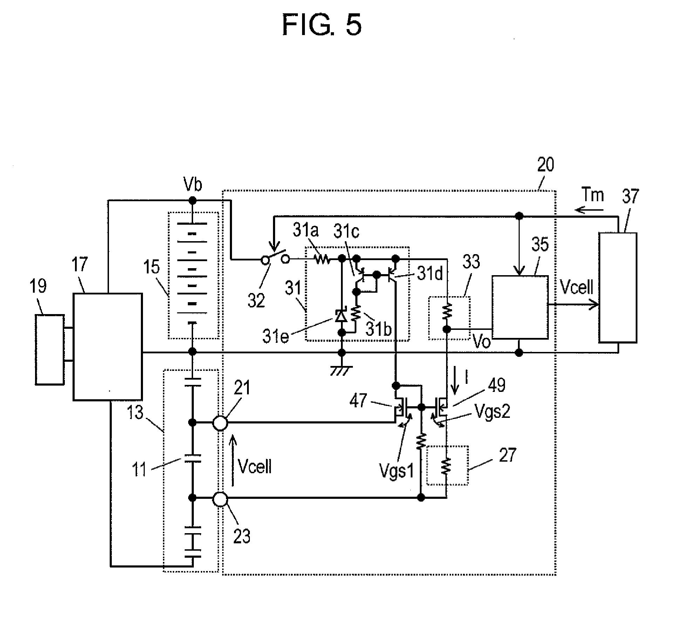

Fig. 4 shows a block circuit diagram of a voltage detector, employing NPN transistors, for storage elements in accordance with the second embodiment of the present invention. Fig. 5 shows a block circuit diagram of a voltage detector, employing N-type FETs, for storage elements in accordance with the second embodiment of the present invention.

In this second embodiment, structural elements similar to those in Fig. 1 have the same reference marks and the detailed descriptions thereof are omitted here. The features of the second embodiment are summarized into the following five points:

(1) Storage section 13 is connected to the negative electrode of secondary battery 15, and this negative electrode is grounded, so that both of positive electrode 21 and negative electrode 23 of storage element 11 are biased to a negative voltage with respect to current sensing circuit 33. This is the reason why first NPN transistor 43 and second NPN transistor 45 shown in Fig. 4 are used instead of first PNP transistor 25 and second PNP transistor 29 shown in Fig. 1.

(2) Since positive electrode 21 and negative electrode 23 of storage element 11 have negative voltages, and an absolute voltage value of the former one is smaller than that of the latter one, the emitter terminal of first NPN transistor 43 is thus connected with positive electrode 21.

(3) A first end of voltage-current converter 27 is connected to negative electrode 23 because of the same reason as discussed above.

(4) Current source 31 has a positive voltage, which is greater than the voltage of positive electrode 21 of storage element 11, so that a drive of current source 31 allows supplying an electric current to the collector terminal of first NPN transistor 43.

(5) The supply of the electric current from current source 31 to first NPN transistor 43 prompts the collector current of second NPN transistor 45 to flow in the opposite direction to that shown in Fig. 1.

Although the current flows in the opposite direction, voltage Vcell across storage element 11 can be found by the same method as described in the case shown in Fig. 1. To be more specific, the supply of an electric current from current source 31 to the collector terminal of first NPN transistor 43 allows collector current I of second NPN transistor 45 to be proportionate to voltage Vcell across storage element 11 (I = Vcell/R) and flow to current sensing circuit 33. This current I is output from current sensing circuit 33 as its output voltage Vo, and then voltage output circuit 35 converts voltage Vo into voltage Vcell across storage element 11.

The foregoing structure and operation allow the voltage detector in accordance with the second embodiment to detect the voltage across storage element 11 accurately and quickly although element 11 is biased to a negative voltage.

In this second embodiment, first NPN transistor 43 and second NPN transistor 45 are employed to form voltage detector 20; however, as the circuit structure shown in Fig. 5 depicts, these transistors can be replaced with first N-type FET 47 and second N-type FET 49 respectively. In this case, similar to the structure shown in Fig. 3, off-resistor 42 is connected between the gate terminal of second N-type FET 49 and negative electrode 23 in order to surely turn off both of FET 47 and FET 49. The circuit shown in Fig. 5 except this part remains unchanged from the circuit shown in Fig. 4, so that circuit elements in Fig. 5 have the same reference marks as those in Fig. 4. In this case, the source terminals, gate terminals, and drain terminals of the FETs are connected to those corresponding to the emitter terminals, base terminals and collector terminals of first NPN transistor 43 and second NPN transistor 45.

The structure shown in Fig. 5 operates in the same way as that shown in Fig. 4, so that voltage Vcell across storage element 11 can be detected at a high speed. Similar to the structure shown in Fig. 3, use of first N-type FET 47 and second N-type FET 49 as shown Fig. 5 allows a current corresponding to the base current not to flow, so that the error can be reduced, and thus voltage Vcell across storage elements 11 can be detected more accurately than that can be detected by the structure shown in Fig. 4.

## EMBODIMENT 3

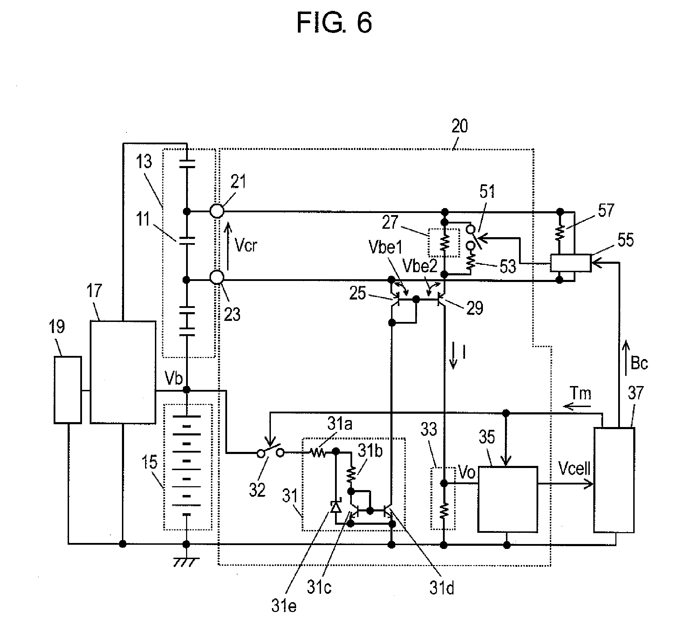

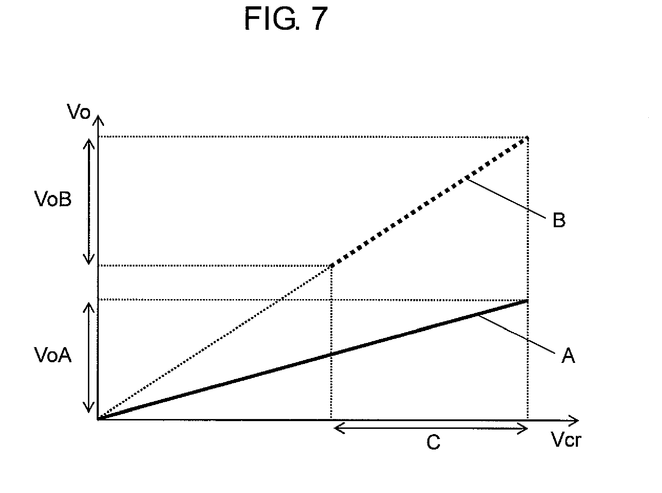

Fig. 6 shows a block circuit diagram of a voltage detector for storage elements in accordance with the third embodiment of the present invention. Fig. 7 shows relations between actual voltage Vcr across an storage element and voltage Vo supplied from a current sensing circuit of a voltage detector for storage elements in accordance with the third embodiment of the present invention. In this third embodiment, structural elements similar to those in Fig. 1 have the same reference marks and the detailed descriptions thereof are omitted here. The structural features of the third embodiment are as described below:

(1) In voltage detector 20, voltage-current converter 27 is formed of a resistor having resistance value R, and resistor selecting switch 51 and selectable resistor 53 having resistance value Rb are connected together in series while both the ends of this series connection are connected to both the ends of voltage-current converter 27. This structure allows selecting the resistance value R of voltage-current converter 27 by turning on or off resistor selecting switch 51.
(2) Bypass control circuit 55 is placed across storage element 11. When voltage Vcell across storage element 11 becomes over-voltage, bypass resistor 57 connected to bypass control circuit 55 can lower this voltage Vcell.
(3) Resistor selecting switch 51 can be turned on or off with bypass control signal Bc transmitted from control circuit 37 via bypass control circuit 55.

The foregoing structure allows lowering the over-voltage of storage element 11, so that the service life of elements 11 can be extended and more reliable performance can be expected. When resistor selecting switch 51 is turned off, voltage-current converter 27 has resistance value R; however, when it is turned on, selectable resistor 53 is connected in parallel with converter 27, so that the combined resistance value will be expressed as $RxRb/(R + Rb)$. In this third embodiment, $R \approx Rb$ is found, so that the combined resistance value becomes approx. a half of resistance value R which converter 27 has when it is turned off. As a result, when resistor selecting switch 51 is turned on, collector current I of second PNP transistor 29 is approximately doubled.

The operation of voltage detector 20 in accordance with the third embodiment is demonstrated hereinafter. In Fig. 6, operation of the featured sections discussed above differ from the operation in the first embodiment; however, the other operation remain unchanged from those demonstrated in the first embodiment, so that detailed descriptions thereof are omitted here, and only the operation of the featured sections are demonstrated.

Control circuit 37 finds voltage Vcell across each one of storage elements 11 through the operation demonstrated in the first embodiment. Assume that the operation causes voltage Vcell to exceed the rated voltage (2.2V is used the rated voltage in this third embodiment), and this over-voltage is applied to any one of storage elements 11. If this status is left as it is, degradation proceeds only in this particular element 11. Control circuit 37 thus transmits bypass control signal Bc to bypass control circuit 55 connected to this particular storage element 11 in order to suppress the degradation. Circuit 55 then controls bypass resistor 57 to connect with both the ends of this particular storage element 11. As a result, this element 11 is discharged by bypass resistor 57, so that voltage Vcr across this particular element 11 lowers. When voltage Vcr lowers to a level not higher than the rated voltage, bypass control circuit 55 separates bypass resistor 57 from this element 11 for halting the discharge.

To indicate explicitly such an over-voltage bypassed status, bypass control circuit 55 turns on resistor selecting switch 51 when bypass resistor 57 is connected across storage element 11. This turn-on allows the following operation: When control circuit 37 finds Vcell across element 11 with the same operation as demonstrated in the first embodiment, voltage-current converter 27 of element 11 in the over-voltage bypassed status has an actual resistance value $RxRb/(R + Rb)$, so that collector current I of second PNP transistor 29 flows in a greater amount than a regular amount. As a result, current sensing circuit 33 outputs a greater amount, so that voltage output circuit 35 outputs a greater voltage Vcell. Detecting this greater voltage Vcell than the regular one allows control circuit 37 to indicate the over-voltage bypassed status of storage element 11 to the outside.

Fig. 7 shows relations between this actual voltage Vcr across this particular element 11 and voltage Vo supplied from the current sensing circuit. In Fig. 7, X-axis represents voltage Vcr across this particular element 11, and Y-axis represents voltage Vo supplied from the current sensing circuit. A regular detection of the voltage across element 11 will draw bold-solid line A representing voltage Vo proportionate to voltage Vcr at an inclination of R0/R.

The over-voltage bypassed status, however, draws bold-broken line B which represents voltage Vo proportionate to voltage Vcr at an inclination of $R0/\{RxRb/(R + Rb)\}$. Since this third embodiment sets $R \approx Rb$, the inclination is approx. $2 \times R0/R$, which is almost twice as much as the inclination of the bold-solid line A. As a result, voltage Vo supplied from the current sensing circuit is approximately doubled. The correlation characteristics represented with bold-broken line B can be found only when resistor selecting switch 51 is turned on, i.e. only when storage element 11 falls in an over-voltage range. To be more specific, approximately doubled voltage Vo is supplied from the current sensing circuit only when voltage Vcr falls in over-voltage range C indicated by the arrow mark along X-axis. As Fig. 7 tells, the range of voltage Vo (indicated by arrow mark VoA along Y-axis) drawn by the regular detection of the voltage across element 11 does not overlap with another range of voltage Vo (indicated by arrow mark VoB along Y-axis) drawn by the detection during the over-voltage status, but these two ranges are completely independent of each other. An output of voltage Vcell supplied from voltage output circuit 35 and being in response to voltage Vo supplied from the current sensing circuit to the outside will prompt an external circuit (not shown) to determine with ease whether or not storage element 11 is in the over-voltage bypassed status.

The structure and the operation discussed above allow the voltage detector to detect a voltage across the storage element accurately at a high speed. On top of that, this voltage detector allows the external circuit to determine with ease whether or not the storage element is in the over-voltage bypassed status.

In this third embodiment, the resistor, of which resistance value is selectable between two values, is used as voltage-current converter 27; however, converter 27 can be formed of multiple selectable resistors and multiple resistor selecting switches connected to the respective selectable resistors in series, so that multi-level selection of resistance values can be available. This structure allows the external circuit to determine with ease not only the over-voltage bypassed status but also an over-discharge status with an output (i.e. voltage Vcell) from voltage output circuit 35. The over-discharge status means that the voltage across storage element 11 decreases to a level lower than a predetermined one.

In this third embodiment, since positive electrode 21 and negative electrode 23 of storage element 11 are biased to a positive voltage, first PNP transistor 25 and second PNP transistor 29 are used, as they are used in Fig. 1. They can be replaced with first P-type FET 39 and second P-type FET 41 as shown in Fig. 3. In the case of positive electrode 21 and negative electrode 23 being biased to a negative voltage, first NPN transistor 43 and second NPN transistor 45 shown in Fig. 4 can be used, or first N-type FET 47 and second N-type FET 49 shown in Fig. 5 can be used instead.

In embodiments 1 - 3, storage section 13 is formed of multiple storage elements 11 connected together in series; however, the present invention is not limited to these examples, and they can be connected in parallel or in series-parallel depending on a power specification required by load 19.

**EMBODIMENT 4**

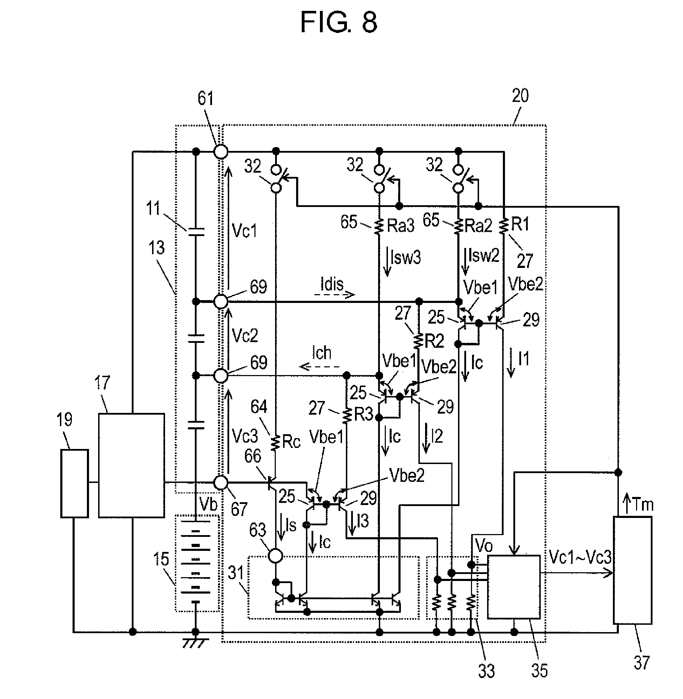

Fig. 8 shows a block circuit diagram of a voltage detector, employing PNP transistors, for storage elements in accordance with the fourth embodiment of the present invention. In Fig. 8, elements similar to those in Fig. 1 have the same reference marks, and detailed descriptions thereof are omitted here. The features of the fourth embodiment are the following seven points. In Fig. 8, three storage elements 11 are used for the description purpose.

(1) Storage section 13 must be formed of multiple storage elements 11 connected together in series. If some parts of elements 11 are connected in parallel, these parts are gathered into one unit, which is then connected to the others in series.

(2) One element 11 having the maximum voltage is selected, and resistor 64 is connected between positive electrode 61 of this element 11 and input section 63 of current source 31. (Positive electrode 61 is referred to as max. voltage positive electrode 61 and corresponds to the positive electrode of the upper most element 11 in Fig. 8. Input section 63 is referred to as reference current input section 63, and resistor 64 is referred to as reference current resistor 64.) Resistor 64 has a resistance value of "Rc", and a current value flowing therein is "Is".

(3) Current compensating resistors 65 are connected between max. voltage positive electrode 61 and each one of negative electrodes 69 respectively except negative electrode 67 of storage element 11 having the minimum voltage. (Negative electrode 67 is referred to as min. voltage negative electrode 67 corresponding to the negative electrode of storage element 11 connected to secondary battery 15 in Fig. 8.) Current compensating resistor 65 connected to the negative electrode of upper most storage element 11 in Fig. 8 has a resistance value of "Ra2", and resistor 65 connected to the next negative electrode has a resistance value of "Ra3". Currents having values of "Isw2" and "Isw3" flow though the resistors 65 discussed above respectively.

(4) Each one of current compensating resistor 65 can supply the sum of current "Ic" drawn from the collector terminal of first PNP transistor 25 connected to each one of the negative electrodes of respective elements 11 and the current "I1", "I2" or "I3" flowing through respective voltage-current converters 27. Resistors 65 also have a resistance value of "Ra2" and "Ra3" which equalize the current values of "Isw2" and "Isw3" flowing though the resistors 65 to the foregoing total current provided that elements 11 have a uniform voltage value of "Vc1", "Vc2", and "Vc3".

(5) Based on the foregoing structures, current value "Is" of current source 31 is to be proportionate to the sum of voltage values Vc (=Vc1 + Vc2 + Vc3) of elements 11 connected together in series. To be more specific, PNP transistor 66 is placed such that its collector is connected to reference current input section 63, its emitter is connected to reference current resistor 64, and its base to min. voltage negative electrode 67.

(6) Driving switches 32 are provided to current source 31 and current compensating resistors 65 respectively for driving/halting the currents of these structural elements. Switch 32 for current source 31 can be connected to a first end (reference current input section 63) of current source 31, and another switch 32 for each one of current compensating resistors 65 can be connected to a first end of resistor 65. As Fig. 8 shows, switch 32 for current source 31 is placed between max. voltage positive electrode 32 and reference current resistor 64. Another switch 32 for each one of current compensating resistors 65 is placed between max. voltage positive electrode 61 and current compensating resistor 65.

(7) Driving switches 32 are turned on simultaneously for driving current source 31 and resistors 65 only when the voltage across element 11 is detected.

The method of determining a resistance value of "Rc" of reference current resistor 64 as well as resistance values of "Ra2" and "Ra3" of respective current compensating resistors 65 is demonstrated hereinafter with reference to the structural feature described in item (4). The resistance values of voltage-current converters 27 connected to the positive electrodes of elements 11 are referred to as "R1", "R2" and "R3" from the top in this order.

First, when every driving switch 32 is turned on, each one of current compensating resistors 65 can supply the sum of current "Ic" drawn from the collector terminal of first PNP transistor 25 and current "I1", "I2" or "I3" flowing through voltage-current converters 27 respectively. And yet, resistors 65 must have a resistance value of "Ra2" and "Ra3" which equalize the current values of "Isw2" and "Isw3" flowing though the resistors 65 to the foregoing total current provided that elements 11 have a uniform voltage value of "Vc1", "Vc2", and "Vc3". Based on the foregoing conditions, the current values can be expressed in the following equations:

$$\mathrm{Isw2 = I2 + Ic} \qquad (1)$$

$$\mathrm{Isw3 = I3 + Ic} \qquad (2)$$

Here is another condition about the voltages:

$$\mathrm{Vc1 = Vc2 = Vc3} \qquad (3)$$

Current source 31 sets current value "Is" flowing to reference current input section 63 to be equal to current value "Ic" drawn from the collector terminals of every first PNP transistor 25. On top of that, current value "Is" is equal to a value of the current flowing through voltage-current converter 27 provided that the voltages of each one of elements 11 are well-balanced. Thus the equation of Is = Ic = I1 = I2 = I3 can be found.

Based on the structure discussed above, equations (1) and (2) can be rewritten as follows:

$$\mathrm{Vc1/Ra2 = Vc2/R2 + Vc/Rc} \qquad (4)$$

$$\mathrm{(Vc1 + Vc2)/Ra3 = Vc3/R3 + Vc/Rc} \qquad (5),$$

and based on the relation of I3 = Is,

$$\mathrm{Vc3/R3 = Vc/Rc} \qquad (6)$$

is found.

Assume that resistance values R1, R2, and R3 of voltage-current converters 27 are equal to one another, i.e. R1 = R2 = R3 = R. Since the sum of voltages Vc of elements 11 = Vc1 + Vc2 + Vc3 as shown in Fig. 8, and equations (4) - (6) are used, the following equations can be found:

$$\mathrm{Rc = 3 \times R} \qquad (7)$$

$$\mathrm{Ra2 = R/2} \qquad (8)$$

$$Ra3 = R \qquad (9)$$

The resistance values of Rc, Ra2, and Ra3 of reference current resistor 64 and each one of current compensating resistors 65 can be thus determined.

The operation of voltage detector 20 for storage elements 11 is demonstrated hereinafter. Similar to the first embodiment, control circuit 37 transmits voltage detection timing signal Tm to driving switches 32 and voltage output circuit 35, then every driving switch 32 is turned on, which prompts current Is to flow through reference current resistor 64 for driving current source 31. As a result, current source 31 draws current Ic from the collector terminal of first PNP transistor 25. At this time, currents "I1", "I2" and "I3" flow from the collector terminals of each one of second PNP transistors 29. The current values of "I1", "I2" and "I3" are to be Is = Ic = I1 = I2 = I3 provided the voltages of respective elements 11 are well-balanced. Therefore, as long as the voltages of elements 11 are well-balanced, the emitter current of first PNP transistor 25 and that of second PNP transistor 29 stay equal to one another although the voltage applied to elements 11 changes. In this case, the voltage across the emitter and the base of these transistors satisfy this equation, i.e. Vbe1 = Vbe2. As a result, accurate current values I1, I2, and I3 proportionate to the voltages across the respective storage elements 11 can be obtained, so that much more accurate voltages can be detected.

On the contrary, when the voltages of respective elements 11 are not balanced, the emitter current of first PNP transistor 25 differs from that of second PNP transistor 29. The difference between them with respect to respective elements 11 is a difference between current value Ic (= Is) in the balanced status and the current value found from the voltage across respective elements 11, namely, I1 = Vc1/R1, I2 = Vc2/R2, and I3 = Vc3/R3. These current differences produce a small voltage difference across the base and the emitter of first PNP transistor 25 and across those of second PNP transistor 29; however, this difference becomes smaller as the voltages are more balanced. Actually, as described later, the voltages across each one of storage elements 11 tend to be controlled to balance with one another although they are not balanced yet, so that the voltages of storage elements 11 are held in the almost balanced status. As a result, the voltage across the base and the emitter become almost equal, i.e. Vbe1 ≈ Vbe2, and the voltage across element 11 thus can be detected accurately enough.

A specific method of detecting the voltage is similar to that demonstrated in the first embodiment, namely, since I1 = VcR/R1, I2 = Vc2/R2, and I3 = Vc3/R3 are found, control circuit 37 gets the voltages across respective elements 11, i.e. Vc1, Vc2, and Vc3, via current sensing circuit 33 and voltage output circuit 35. The voltages across each element 11 can be thus detected at a high speed as they can be detected in the first embodiment.

Since resistance value "Rc" of reference current resistor 64 and resistance values "Ra2" and "Ra3" of current compensating resistors 65 are determined such that equations (1) and (2) can be established, no current flows from respective electrodes 69. Max. voltage positive electrode 61 and min. voltage negative electrode 67 supply a current via charge/discharge device 17, so that no current is taken out from storage element 11 during the detection of the voltage although it is taken out in the first embodiment. As a result, the detection of the voltages does not cause the voltages of elements 11 to lose balance.

Resistors value "Rc", "Ra2", and "Ra3" are determined such that the voltages across each one of storage elements 11 become equal to each other, i.e. Vc1 = Vc2 = Vc3. Therefore a turn-on of driving switch 32 prompts current compensating resistor 65 to strike a balance between the voltages across respective storage elements 11. As a result, if dispersion exists between the voltages, the operation of this voltage detection allows striking a balance between the voltages across elements 11.

The operation of striking a balance between the voltages is specifically demonstrated hereinafter. In Fig. 8, assume that the voltages are out of balance, e.g. voltage Vc2 across storage element 11 is greater than the other voltages Vc1 and Vc3. If these voltages are well-balanced, the equation of Vc1 = Vc2 = Vc3 = Vc/3 can be found. Thus the status of this out of balance can be expressed as follows:

$$Vc2 > Vc/3 \qquad (10)$$

$$Vc1 < Vc/3 \qquad (11)$$

$$Vc3 < Vc/3 \qquad (12)$$

Then substitute the relations of (7), (8), and (11) for the equations Isw2 = Vc1/Ra2 and Is = Ic = Vc/Rc, thereby finding the relation of

$$\mathrm{Isw} = \mathrm{Vc1}/(\mathrm{R}/2) < (\mathrm{Vc}/3)/(\mathrm{R}/2) = 2\mathrm{Ic}.$$

Then the relation of

$$\mathrm{Isw2} < 2 \times \mathrm{IC} \qquad (13)$$

is found.

In a similar way, Isw3 = (Vc1 + Vc2)/Ra3, and Is = Ic = Vc/Rc are found, and substitute relations (9) - (11) for these relations to find the relation of

$$\mathrm{Isw3} = (\mathrm{Vc1} + \mathrm{Vc2})/\mathrm{R} > 2 \times \mathrm{Vc}/3/\mathrm{R} = 2\mathrm{Ic}$$

Then the relation of

$$\mathrm{Isw3} > 2 \times \mathrm{Ic} \qquad (14)$$

is found.

Since voltage Vc2 is greater than the other voltages Vc1 and Vc3, current "Is" flowing through voltage-current converter 27 having resistance value "R2" is greater than current "Ic" that flows when the voltages are well-balanced. Thus the relation of

$$\mathrm{I2} > \mathrm{Ic} \qquad (15)$$

is found.

In a similar way, current "I3" flowing through voltage-current converter 27 having resistance value "R3" is smaller than current "Ic", so that the relation of

$$\mathrm{I3} < \mathrm{Ic} \qquad (16)$$

is found.

As the relations (13) - (16) indicate, the respective currents differ from each other in current value, so that the difference between the currents is drawn from storage element 11 or supplied to storage element 11. The broken lines with arrow marks in Fig. 8 show the flows of such electric currents. Discharge current Idis of storage element 11 flows from electrode 69, and charge current Ich of storage element 11 flow to electrode 69, so that storage element 11 is discharged or charged. In the specific example discussed above, the discharge and the charge change voltage Vc2 to be smaller, voltages Vc1 and Vc3 to be greater. As a result, voltages Vc1 - Vc3 across each one of storage elements 11 can be well-balanced and become stable.

On the contrary, when voltage Vc2 is smaller than the other voltages Vc1 and Vc3, the discharge and the charge of respective elements 11 are just inversed, which yet results in striking a balance between these voltages.

The foregoing discussion proves that whatever voltages Vc1 - Vc3 are unbalanced with each other, they can be discharged or charged to be balanced, and to become stable.

Next, after the detection of voltages Vc1 - Vc3 across respective storage elements 11, control circuit 37 turns off every driving switch 32. The operation at this time is the same as that demonstrated in the first embodiment. The turn-off of every switch 32 allows voltage detector 20 to consume no power at all.

The structure and the operation discussed above allow the voltage detector to detect the voltages across respective storage elements 11 at a high speed, and on top of that, no current is taken out from respective storage elements 11, thereby preventing the voltages from losing a balance between them. As a result, the voltage detector can detect the voltages accurately.

In this fourth embodiment, three storage elements 11 are connected together in series; however, the number of elements 11 can be two, four or more than four with an advantage similar to what is discussed above.

In this fourth embodiment, first PNP transistor 25 and second PNP transistor 29 can be replaced with P-type FETs as discussed in the first embodiment.

As discussed in the second embodiment, storage section 13 and secondary battery 15 can be reversely connected, and max. voltage positive electrode 61 of storage section 13 can be connected to the negative electrode of secondary battery 15. This structure also produces an advantage similar to what is discussed above; however, the connections in this case should be changed as follows:

(1) Reference current resistor 64 is put between min. voltage negative electrodes 67 among multiple storage elements 11 and reference current input section 63 of current source 31.
(2) Current compensating resistor 65 is put between the min. voltage negative electrodes 67 among multiple storage elements 11 and the positive electrodes except max. voltage positive electrode 61.
(3) First PNP transistor 25 and second PNP transistor 29 are replaced with NPN transistors as shown in Fig. 4.
(4) Current compensating resistor 65 has a resistance value such that resistor 65 can supply the sum of the current supplied to the collector terminal of the first PNP transistor connected to the positive electrode of respective elements 11 and the current flowing through one of respective voltage-current converters 27, and this total current becomes equal to the current flowing through one of respective current compensating resistors 65 provided the voltages across respective elements 11 are equal. The respective resistance values can be found through the same calculating method as that discussed above.

In the foregoing changes, the first NPN transistor and the second NPN transistor can be replaced with N-type FETs as discussed in the first embodiment.

In embodiments 1 - 4, electrically double-layered capacitors are used as storage elements 11; however, they can be replaced with electrochemical capacitors or other types of storage elements. Storage section 13 is connected to secondary battery 15 in series; however, the present invention is not limited to this example. They can be connected in parallel.

**INDUSTRIAL APPLICABILITY**

The voltage detector of the present invention can directly detect the voltages across respective storage elements, so that the detection can be done accurately within a shorter time. The voltage detector is useful for detecting voltages of storage elements installed in, e.g. vehicles which encounter a great voltage variation.

**Claims**

1. A voltage detector for a storage element that includes a positive electrode and a negative electrode, the voltage detector comprising:

a first transistor of which emitter terminal or source terminal is connected to a first electrode of the storage element, and of which base terminal or gate terminal is connected to a collector terminal or a drain terminal thereof respectively;
a voltage-current converter of which first end is connected to a second electrode of the storage element;
a second transistor of which emitter terminal or source terminal is connected to a second end of the voltage-current converter, and of which base terminal or gate terminal is connected to the base terminal or the gate terminal of the first transistor respectively;
a current source connected to the collector terminal or the drain terminal of the first transistor for drawing an electric current from the collector terminal or the drain terminal;
a current sensing circuit connected to the collector terminal or the drain terminal of the second transistor for sensing a collector current or a drain current; and
a voltage output circuit for outputting a voltage across the first electrode and the second electrode of the storage element based on an output from the current sensing circuit,
wherein the first electrode of the storage element is biased to a voltage, having a polarity identical to that of the second electrode, with respect to the current sensing circuit.

2. The voltage detector of claim 1, wherein the first electrode of the storage element is a negative electrode, the second electrode thereof is a positive electrode, and the first transistor and the second transistor are PNP transistors.

3. The voltage detector of claim 1, wherein the first electrode of the storage element is a negative electrode, the second electrode thereof is a positive electrode, and the first transistor and the second transistor are P-type FETs.

4. The voltage detector of claim 1, wherein the first electrode of the storage element is a positive electrode, the second electrode thereof is a negative electrode, and the first transistor and the second transistor are NPN transistors.

5. The voltage detector of claim 1, wherein the first electrode of the storage element is a positive electrode, the second electrode thereof is a negative electrode, and the first transistor and the second transistor are N-type FETs.

6. The voltage detector of claim 1 further comprising a driving switch connected to the current source for driving or halting the current source, wherein the driving switch is turned on for driving the current source only when the voltage across the storage element is detected.

7. The voltage detector of claim 1, wherein the voltage-current converter is formed of a resistor of which resistance value is selectable.

8. The voltage detector of claim 1, wherein a current of the current source is proportionate to the voltage across the first and the second electrodes of the storage element.

9. The voltage detector of claim 1, wherein the first electrode of the storage element is a negative electrode and the second electrode thereof is a positive electrode,
wherein the first and the second transistors are PNP transistors or P-type FETs,
wherein a plurality of the storage elements are connected together in series,
wherein a reference current resistor is connected between a positive electrode of the storage element having a maximum voltage among the storage elements and a reference current input section of the current source;
wherein a current compensating resistor is connected between the positive electrode of the storage element having the maximum voltage among the storage elements and each one of the negative electrodes of the storage elements except the negative electrode of the storage element having a minimum voltage among the storage elements,
wherein the current compensating resistor has a resistance value such that the resistor can supply a sum of a current drawn from the collector terminal of the first PNP transistor or from the drain terminal of the P-type FET and one of currents flowing through the respective voltage-current converters, and the currents flowing through the converters equal to the sum of the currents provided the voltage across each one of the storage devices is equal to each other, and
wherein the current value of the current source is proportionate to a total voltage of the storage elements connected together in series.

10. The voltage detector of claim 3, wherein the first electrode of the storage elements is a positive electrode and the second electrode thereof is a negative electrode,
wherein the first and the second transistors are NPN transistors or N-type FETs,
wherein a plurality of the storage elements are connected together in series,
wherein a reference current resistor is connected between the negative electrode of the storage element having a minimum voltage among the storage elements and a reference current input section of the current source;
wherein a current compensating resistor is connected between the negative electrode of the storage element having the minimum voltage among the storage elements and each one of the positive electrodes of the storage elements except the positive electrode of the storage element having a maximum voltage among the storage elements,
wherein the current compensating resistor has a resistance value such that the resistor can supply a sum of a current supplied to the collector terminal of the first NPN transistor or to the drain terminal of the N-type FET and one of currents flowing through the respective voltage-current converters, and the currents flowing through the converters equal to the sum of the currents provided the voltage across each one of the storage devices is equal to each other, and
wherein the current value of the current source is proportionate to a total voltage of the storage elements connected together in series.

**11.** The voltage detector of claim 8 or claim 9 further comprising driving switches connected to the current source and a first end of the current compensating resistor for driving or halting the currents of the current source and the current of the current compensating resistor, and the driving switches are turned on for driving the currents of the current source and the current of the current compensating resistor only when the voltage across the storage element is detected.

**Amended claims under Art. 19.1 PCT**

**1.** (Currently Amended) A voltage detector for a <u>plurality of storage elements connected together in series and each one of</u> the storage elements including a positive electrode and a negative electrode, the voltage detector comprising:

a first transistor of which emitter terminal or source terminal is connected to a first electrode <u>of each one</u> of the storage elements, and of which base terminal or gate terminal is connected to a collector terminal or a drain terminal thereof respectively;

a voltage-current converter of which first end is connected to a second electrode <u>of each one</u> of the storage elements;

a second transistor of which emitter terminal or source terminal is connected to a second end of the voltage-current converter, and of which base terminal or gate terminal is connected to the base terminal or the gate terminal of the first transistor respectively;

a current source connected to the collector terminal or the drain terminal of the first transistor for drawing an electric current from the collector terminal or the drain terminal;

a current sensing circuit connected to the collector terminal or the drain terminal of the second transistor for sensing a collector current or a drain current; and

a voltage output circuit for outputting a voltage across the first electrode and the second electrode <u>of each one</u> of the storage elements based on an output from the current sensing circuit,

wherein the first electrode of the storage element is biased to a voltage, having a polarity identical to that of the second electrode, with respect to the current sensing circuit, and a current value of the current source is proportionate to a total voltage of the storage elements connected together in series.

**2.** - 8. (Retained Unchanged)

**9.** (Currently Amended) The voltage detector of claim 1, wherein the first electrode of each one of the storage elements is a negative electrode and the second electrode thereof is a positive electrode,

wherein the first and the second transistors are PNP transistors or P-type FETs,

wherein a reference current resistor is connected between a positive electrode of the storage element having a maximum voltage among the storage elements and a reference current input section of the current source;

wherein a current compensating resistor is connected between the positive electrode of the storage element having the maximum voltage among the storage elements and each one of the negative electrodes of the storage elements except the negative electrode of the storage element having a minimum voltage among the storage elements, and

wherein the current compensating resistor has a resistance value such that the resistor can supply a sum of a current drawn from the collector terminal of the first PNP transistor or from the drain terminal of the P-type FET and one of currents flowing through the respective voltage-current converters, and the currents flowing through the converters equal to the sum of the currents provided the voltage across each one of the storage devices is equal to each other.

**10.** (Currently Amended) The voltage detector of claim 1, wherein the first electrode of the storage element is a positive electrode and the second electrode thereof is a negative electrode,

wherein the first and the second transistors are NPN transistors or N-type FETs,

wherein a reference current resistor is connected between the negative electrode of the storage element having a minimum voltage among the storage elements and a reference current input section of the current source;

wherein a current compensating resistor is connected between the negative electrode of the storage element having the minimum voltage among the storage elements and each one of the positive electrodes of the storage elements except a positive electrode of the storage element having a maximum voltage among the storage elements, and

wherein the current compensating resistor has a resistance value such that the resistor can supply a sum of a current supplied to the collector terminal of the first NPN transistor or to the drain terminal of the N-type FET and one of currents flowing through the respective voltage-current converters, and the currents flowing through the converters equal to the sum of the currents provided the voltage across each one of the storage devices is equal to each other,

**11.** (Currently Amended) The voltage detector of claim 9 or claim 10 further comprising driving switches connected to the current source and a first end of the current compensating resistor for driving or halting the currents of the current source and the current compensating resistor, and the driving switches are turned on for driving the currents of the current source and the current compensating resistor only when the voltage across the storage element is detected.

# FIG. 1

# FIG. 2

# FIG. 3

# FIG. 4

# FIG. 5

# FIG. 6

# FIG. 7

# FIG. 8

# FIG. 9

## INTERNATIONAL SEARCH REPORT

| International application No. |
|---|
| PCT/JP2007/071465 |

**A. CLASSIFICATION OF SUBJECT MATTER**
*G01R19/00* (2006.01) i

According to International Patent Classification (IPC) or to both national classification and IPC

**B. FIELDS SEARCHED**

Minimum documentation searched (classification system followed by classification symbols)
G01R19/00

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2005-3394 A  (Sanken Electric Co., Ltd.),<br>06 January, 2005 (06.01.05),<br>Full text; all drawings<br>(Family: none) | 1-8 |
| Y | JP 11-160368 A  (TDK Corp.),<br>18 June, 1999 (18.06.99),<br>Full text; all drawings<br>(Family: none) | 1-8 |
| A | JP 2001-265451 A  (AutoNetworks Technologies, Ltd.),<br>28 September, 2001 (28.09.01),<br>Full text; all drawings<br>(Family: none) | 1-11 |

☐ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 25 January, 2008 (25.01.08) | 05 February, 2008 (05.02.08) |

| Name and mailing address of the ISA/<br>Japanese Patent Office | Authorized officer |
|---|---|
| Facsimile No. | Telephone No. |

Form PCT/ISA/210 (second sheet) (April 2007)

**EP 2 103 947 A1**

**REFERENCES CITED IN THE DESCRIPTION**

**Patent documents cited in the description**

- JP 2002281681 A